(19) **Europäisches Patentamt**
**European Patent Office**
**Office européen des brevets**

(11) **EP 4 510 052 A1**

(12) **EUROPEAN PATENT APPLICATION**

(43) Date of publication:
**19.02.2025 Bulletin 2025/08**

(21) Application number: **24194735.7**

(22) Date of filing: **15.08.2024**

(51) International Patent Classification (IPC):
*G06Q 10/04* (2023.01)    *G06F 30/398* (2020.01)
*H05K 3/00* (2006.01)

(52) Cooperative Patent Classification (CPC):
**G06Q 10/04; G06F 30/398; H05K 3/0005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **17.08.2023 US 202363520267 P**

(71) Applicant: **3M Innovative Properties Company**
**St. Paul, MN 55133-3427 (US)**

(72) Inventor: **Krause, Adam R.**
**Charlotte, NC (US)**

(74) Representative: **Mathys & Squire**
**Theatinerstraße 7**
**80333 München (DE)**

(54) **AUTOMATED METHOD FOR PRINTED CIRCUIT BOARD INTER-LAYER ELEMENT CLEARANCE**

(57)    A computer-implemented method for evaluating a minimum clearance distance between a first conductive element and a second conductive element included in a printed circuit board (PCB) is provided. The PCB comprises a plurality of conductive layers and a plurality of conductive elements, where each conductive layer comprises one or more conductive elements. The plurality of conductive layers comprises one or more outer conductive layers. The method comprises selecting a first conductive element (A) disposed on a first outer conductive layer and a second conductive element (B) disposed on a second outer conductive layer of the PCB, a clearance between which has a minimum spacing requirement. The method also comprises creating polygons of the first and second conductive elements, wherein a polygon of the first conductive element is A' and a polygon of the second conductive element is B'. The method also comprises determining if there is at least one conductive layer disposed between A' and B'. If no conductive layer is disposed between A' and B', then A" and B" are created on an evaluation layer. The method further comprises calculating a shortest unshielded distance (dxy) between A" and B". The method also comprises using a distance between the conductive layers (dz), and calculating a distance (d), wherein $d = \sqrt{dxy^2 + dz^2}$. If the calculated distance d is less than the minimum spacing requirement, a violation is indicated.

EP 4 510 052 A1

10

12 — Select 2 conductive elements (A, B)

14 — Create polygons for 1st and 2nd conductive elements (A', B')

16 — Determine if there is at least 1 conductive layer disposed between A, B

**YES**

**NO**

19 — See method 100

18 — Calculate shortest distance (dxy) between A'', B''

20 — Use layer spacing distance to calculate (d)
$$d = \sqrt{dxy^2 + dz^2}$$

22 — If d < min spacing distance requirement, indicate violation

24 — Repeat for additional conductive elements

**FIG. 1A**

## Description

### Technical Field

The present disclosure relates generally to printed circuit boards and, in particular, to an automated method for evaluating element clearances on printed circuit boards to be compliant with intrinsic safety standards.

### Background

Many modern safety devices include various electronic components mounted on and electrically connected by a printed circuit board (PCB). The safety devices may be operated by safety personnel in hazardous environments (e. g., explosive atmosphere). The safety devices operating in the hazardous environments may be required to be designed in such a manner that they operate safely even under certain fault conditions. To operate safely in the hazardous environments, the PCB of the safety devices may be designed in compliance with intrinsic safety (IS) standards, such as IEC 60079. The safety devices including the PCB designed in compliance with the IS standards may be referred to as "intrinsically safe".

In order for the safety devices to be intrinsically safe, a design of the PCB may have to meet certain predefined design criteria defined by the IS standards. Specifically, a minimum clearance between certain conductive elements of the PCB may be required for isolation purposes.

Existing PCB design software may be used to determine minimum clearances between conductive elements of a PCB in a single conductive layer. However, for multi-layer structures, determining minimum clearance standards is done by eye. Further, the existing PCB design software cannot determine minimum clearances between conductive elements disposed in different conductive layers of the PCB (in the case of a multi-layer PCB).

Therefore, designing a PCB for intrinsically safe devices may include multiple iterations of calculations, which may be time consuming. Furthermore, designing the PCB for the intrinsically safe devices may be prone to calculation errors and thereby may fail under worst-case fault conditions.

### Summary

In one aspect, a computer-implemented method for evaluating a minimum clearance distance between a first conductive element and a second conductive element included in a printed circuit board (PCB) is provided. The PCB comprises a plurality of conductive layers and a plurality of conductive elements, where each conductive layer comprises one or more conductive elements. The plurality of conductive layers comprises one or more outer conductive layers. The method is executed by one or more processors of one or more computing devices.

In one aspect, the method comprises selecting a first conductive element (A) disposed on a first outer conductive layer and a second conductive element (B) disposed on a second outer conductive layer of the PCB, a clearance between which has a minimum spacing requirement. The method also comprises creating polygons of the first and second conductive elements, wherein a polygon of the first conductive element is A' and a polygon of the second conductive element is B'. The method also comprises determining if there is at least one conductive layer disposed between A and B. If no conductive layer is disposed between A' and B', then A" and B" are created on an evaluation layer. The method further comprises calculating a shortest unshielded distance (dxy) between A" and B". The method also comprises using a distance between the conductive layers (dz), and calculating a distance (d), wherein

$$d = \sqrt{dxy^2 + dz^2}$$

. If the calculated distance d is less than the minimum spacing requirement, a violation is indicated.

In another aspect, the computer-implemented method further comprises selecting a third conductive element (C) of the PCB. The method also comprises creating polygons of the first and third conductive elements, wherein a polygon of the first conductive element is A' and a polygon of the third conductive element is C'. The method also comprises determining if there is at least one conductive layer disposed between A and C. If no conductive layer is disposed between conductive elements A' and C', then A" and C" are created on the evaluation layer. The method further comprises calculating the shortest distance (dxy) between A' and C'. The method also comprises using a distance between the outer conductive layers (dz), calculating the distance (d),

wherein $d = \sqrt{dxy^2 + dz^2}$ . If the calculated distance d is less than the minimum spacing requirement, a violation is indicated.

In another aspect, the plurality of conductive layers includes a first outer conductive layer, a second outer conductive layer, and at least one internal conductive layer disposed between the outer conductive layers. For each internal conductive layer, the computer-implemented method further comprises creating a polygon of each element disposed on the internal conductive layer. For a first internal conductive layer, the method comprises implementing a union operator to create a first polygon mask layer (Mx) and implementing an intersection operator to determine where the first polygon mask layer overlaps the polygon of the first conductive element A'.

In another aspect, the computer-implemented method further comprises implementing a difference operator to remove areas of the polygon of the first conductive element A' where the first polygon mask layer Mx overlaps the polygon of the first conductive element A', creating A" on the evaluation layer.

In another aspect, the computer-implemented method further comprises implementing an intersection operator to determine where the first polygon mask layer overlaps the polygon of the second conductive element B' and implementing a difference operator to remove areas of the polygon of the second conductive element B' where the first polygon mask layer Mx overlaps the polygon of the second conductive element B', creating B" on the evaluation layer.

In another aspect, the computer-implemented method further comprises calculating a shortest unshielded distance (dxy) between A" and B" on the evaluation layer and using a distance between the conductive layers (dz) to calculate an unshielded distance (d), wherein $d = \sqrt{dxy^2 + dz^2}$. If the calculated distance d is less than the minimum spacing requirement, indicating a violation.

In another aspect, where the plurality of conductive layers includes first and second internal conductive layers each disposed between the outer layers, the computer-implemented method further comprises, for the second internal conductive layer, implementing a union operator to create a second polygon mask layer (My). The method further comprises implementing an intersection operator to determine where the second polygon mask layer overlaps the polygon of the first conductive element A'. The method further comprises implementing a difference operator to remove areas of the polygon of the first conductive element A' where the second polygon mask layer My overlaps the polygon of the first conductive element A', forming A" on the evaluation layer. The method further comprises implementing an intersection operator to determine where the second polygon mask layer overlaps the polygon of the second conductive element B'. The method further comprises implementing a difference operator to remove areas of the polygon of the second conductive element B' where the second polygon mask layer My overlaps the polygon of the second conductive element B', forming B" on the evaluation layer. The method further comprises determining a shortest unshielded distance (dxy) between A" and B" on the evaluation layer and using a distance between the conductive layers (dz) to calculate an unshielded distance (d), wherein $d = \sqrt{dxy^2 + dz^2}$. If the calculated distance d is less than the minimum spacing requirement, a violation is indicated.

## Brief Description of the Drawings

Exemplary embodiments disclosed herein may be more completely understood in consideration of the following detailed description in connection with the following figures. The figures are not necessarily drawn to scale. Like numbers used in the figures refer to like components. However, it will be understood that the use of a number to refer to a component in a given figure is not intended to limit the component in another figure labeled with the same number.

FIG. 1A is a flowchart of a method for evaluating a minimum clearance distance between a first conductive element and a second conductive element included in a printed circuit board (PCB) according to one embodiment of the present disclosure (a two layer PCB) and FIG. 1B is a flowchart of another method for evaluating a minimum clearance distance between a first conductive element and a second conductive element included in a printed circuit board (PCB) according to another embodiment (a PCB having at least three conductive layers) of the present disclosure;

FIG. 2 is an isometric view of an exemplary printed circuit board (PCB); and

FIGS. 3A - 3F show various schematic views of different method steps according to one embodiment of the present invention.

## Detailed Description

In the following description, reference is made to the accompanying figures that form a part thereof and in which various embodiments are shown by way of illustration. It is to be understood that other embodiments are contemplated and may be made without departing from the scope or spirit of the present disclosure. The following detailed description, therefore, is not to be taken in a limiting sense.

The present disclosure relates to a computer-implemented method for evaluating a minimum clearance distance between a first and a second conductive element included in a printed circuit board (PCB). The PCB comprises a plurality of conductive layers and a plurality of conductive elements. Each conductive layer comprises one or more conductive elements. The plurality of conductive layers includes one or more outer conductive layers. The computer-implemented method may be executed by one or more processors of one or more computing devices. In some embodiments, the computer-implemented method may be an automated process. In other words, the computer-implemented method may be automated by the one or more processors of the one or more computing devices. The PCB evaluated by the computer-implemented method may be used in safety devices used in a number of different applications, such as firefighting, mining, hazmat work, and so forth. Some examples of such safety devices include, but are not limited to, powered air-purifying respirators (PAPR), self-contained breathing apparatus (SCBA), and thermal imaging cameras (TIC).

Printed circuit board (PCB) design for intrinsic safety certification requires certain PCB elements to have a specific minimum clearance from other elements. This requirement applies not just for elements on the same PCB layer, but between layers as well. PCB design software can detect clearance violations on a single layer, but not between layers. A traditional method of evaluating clearances between layers is through visual inspection by the designers and reviewers. This process can take a very lengthy time (e. g., days or weeks) depending on complexity of the PCB.

A commercially available program for designing PCBs, such as Altium (available at www.altium.com), does not include a way for designers to determine if a PCB having conductive elements, such as conductive tracks, conductive pads, conductive traces, conductive fills, and the like, disposed on multiple levels meet intrinsic safety standards and requirements. Accordingly, the method described herein evaluates element clearances between layers in an automated process. When using a commercially available PCB design software system, such as Altium, the method can be implemented as a software plug-in, where the method is coded in a programming language and added to the design software during the PCB design phase. Using the automated methods described herein cuts the evaluation time down to a much shorter time, e. g., seconds or minutes. In addition, the method can also allow the PCB to be minimized in size while still maintaining intrinsic safety clearances.

The computer-implemented method can ensure a PCB design having a distance between the conductive elements greater than or equal to a minimum clearance that satisfies the intrinsic safety (IS) standards, such as IEC 60079. "Intrinsic safety" (IS) is a protection model employed in potentially explosive atmospheres and relies on the safety devices being designed so that it is unable to release sufficient energy by either thermal or electrical means that can cause an ignition of a flammable gas. A published discussion of this protection technique can be found at www.iec.ch. Part of (International Electrotechnical Commission) IEC 60079 specifies the construction and testing of intrinsically safe apparatus intended for use in an explosive gas atmosphere and for associated apparatus, such as the safety devices, which is intended for connection to intrinsically safe circuits which enter such atmospheres. These are locations where ignitable concentrations of flammable gases, vapors, liquids, dust, or easily ignitable fibers are present continuously, or are present for long periods of time.

The minimum clearance between the conductive elements of the PCB may be required for isolation purposes. The computer-implemented method may further reduce errors while designing the PCB.

Therefore, the computer-implemented method may ensure that a PCB design is compliant with safety standards, such as the IS standards. In other words, a PCB designed using the computer-implemented method may be intrinsically safe and operate safely in the hazardous environments even during worst-case fault conditions.

A previous method involved moving one element onto the same layer as the other element in question. Their two-dimensional (2D) distance was measured, and then the first element was moved to its original layer. Knowledge of the inter-layer distances allowed true clearances to be calculated. The challenge for this other method came when the two elements in question were shielded from each other by other elements on layers between them. The previous method tried to determine if the elements were totally or partially covered by the shielding elements. If they were partially shielded, it was difficult to know if they truly violated spacing requirements.

The method described herein is different from the previous method because it uses simulated shapes (e. g., polygons), and mathematical operations such as 'union', 'intersection', and 'difference' operators to modify those polygons prior to evaluating clearance distances. As such, the method described herein provides an integrated way of determining if the two elements are truly shielded, rather than determining this condition after the fact.

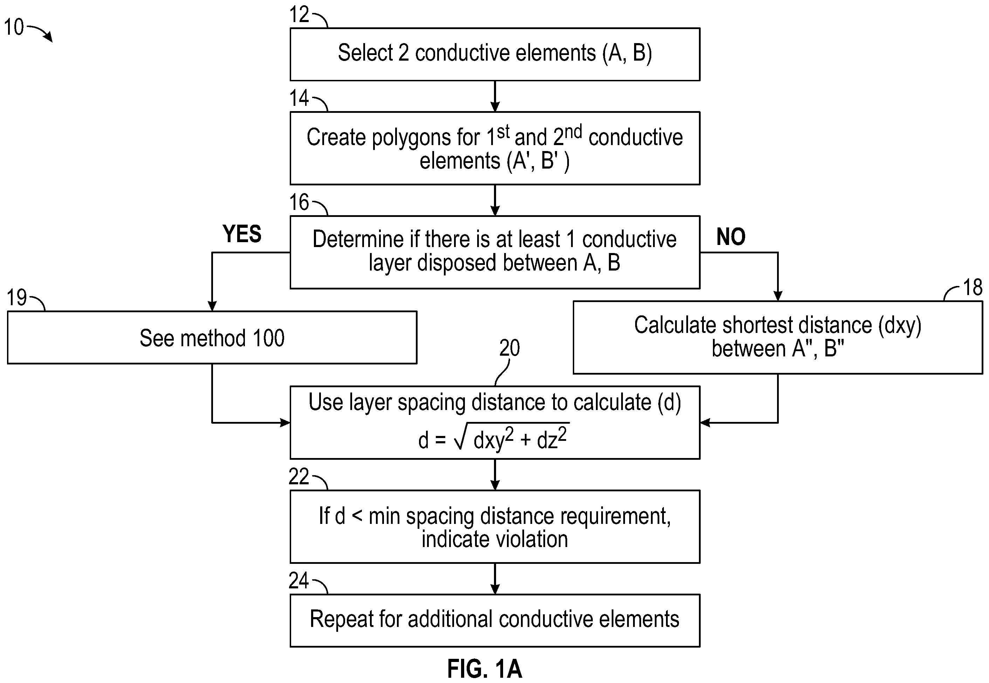

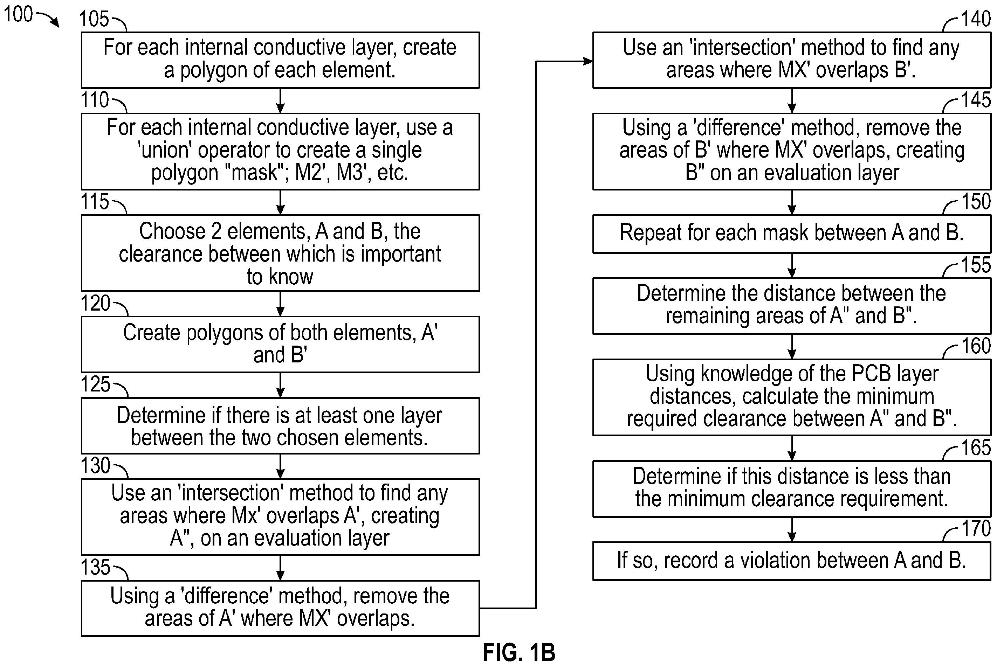

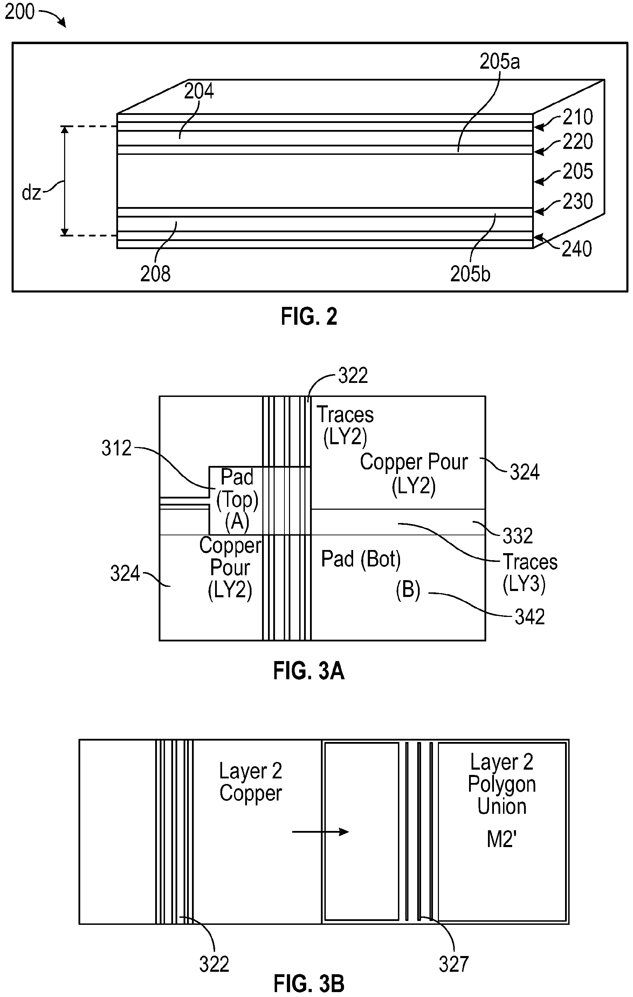

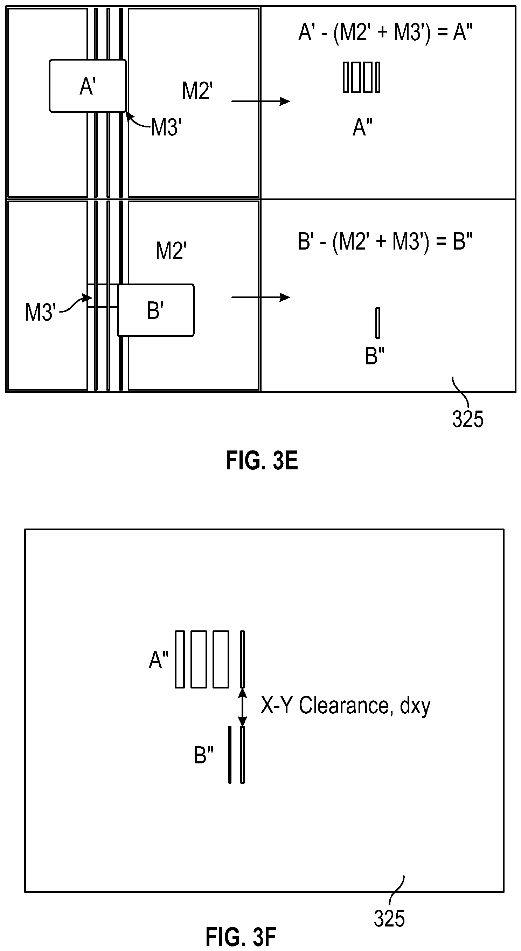

Figs. 1A and 1B are flowcharts of embodiments 10, 100 of a method for evaluating a minimum clearance distance between a first and a second conductive element included in a printed circuit board (PCB), such as PCB 200 shown in Fig. 2. To help further illustrate the minimum distance evaluation method described herein, Figs. 3A-3F show different views of the various steps of the flowcharts of Figs. 1A and 1B.

Fig. 2 is an isometric view of exemplary PCB 200. PCB 200 includes a core 205. However, in some aspects, the PCB 200 may include multiple cores, such as two, three, four, etc., as per desired application attributes. The core 205 may include a glass-reinforced epoxy laminate material which is pressed, hardened, and cured with heat. In some embodiments, the core 205 may include Polytetrafluoroethylene (PTFE), Flame Retardant (FR) -1, FR-2, FR-3, Composite Epoxy Materials (CEM) -1, CEM-2, CEM-3, and the like. In some other embodiments, the core 205 may include FR-4. As shown in FIG. 2, the core 205 includes a first major surface 205a, and a second major surface 205b opposite to the first major surface 205a.

The PCB 200 further includes one or more conductive layers. In the illustrated embodiment of FIG. 2, the PCB 200 includes a plurality of conductive layers 210, 220, 230, 240. However, in some other embodiments, the PCB 200 may include only one conductive layer (in case of a single-layer PCB). Specifically, the PCB 200 includes a second conductive layer 220 disposed on the first major surface 205a of the core 205, and a third conductive layer 230 disposed on the second major surface 205b of the core 205. The second conductive layer 220 and the third conductive layer 230 may be interchangeably referred to as inner conductive layers 220, 230.

As used herein, the term "conductive" or "electrically conductive" refers to any component or material that is an electrical conductor, i.e., can conduct electrical current. For the purpose of this disclosure, an electrical conductor has a conductivity of at least $10^3$ Siemens per meter (S/m).

The PCB 200 may further include a first prepreg 204 disposed on the second conductive layer 220, and a second prepreg 208 disposed on the third conductive layer 230. The first prepreg 204 and the second prepreg 208 may include a fiberglass fabric impregnated with a resin. The resin may be partially cured, but not hardened, while being applied on the second and third conductive layers 220, 230 during manufacturing of the PCB 200.

As shown in FIG. 2, a first conductive layer 210 may be disposed on the first prepreg 204, and a fourth conductive layer 240 may be disposed on the second prepreg 208.

In some cases (e. g., single-layer PCB), the PCB may include only one outer conductive layer. However, in some other cases (e. g., multi-layer PCB), the PCB may include more than one outer conductive layer. As shown in FIG. 2, the one or more conductive layers include one or more outer conductive layers 210, 240. In the illustrated embodiment of FIG. 2, the first conductive layer 210 and the fourth conductive layer 240 may be interchangeably referred to as outer conductive layers 210, 240. That is, in the illustrated embodiment of FIG. 2, the plurality of conductive layers includes two outer conductive layers 210, 240.

In some embodiments, each of the conductive layers may be made of an electrically conductive material, such as copper. In some other embodiments, each of the conductive layers may include a dielectric material and conductive components (not shown) disposed or embedded in the dielectric material. The conductive components may include conductive traces, conductive pads, and so forth. The conductive components may electrically connect the different parts of the respective conductive layers. In some cases, the conductive components can be formed by etching the respective conductive layers.

The PCB 200 defines mutually orthogonal X, Y and Z-axes. The X and Y-axes are in-plane axes of the PCB 200, while the Z-axis is a transverse axis disposed along a thickness of the PCB 200. In other words, the X and Y-axes are disposed along a plane of the PCB 200, while the Z-axis is perpendicular to the plane of the PCB 200. The first prepreg 204, the core 205, and the second prepreg 208 of the PCB 200 may be disposed adjacent to each other along the Z-axis.

The core 205 may have a thickness ranging from about 0.5 millimeters (mm) to about 2.5 mm along the Z-axis. Furthermore, the first and second prepregs 204, 208 may have a thickness ranging from about 0.5 mm to about 2.5 mm along the Z-axis. However, the thicknesses of the core 205, the first prepreg 204, and the second prepreg 208 may vary as per desired application attributes.

The PCB 200 further includes a plurality of conductive elements (see e. g., conductive elements (conductive pads) 312 and 342 in Fig, 3A), such that one or more conductive elements are included in each conductive layer 210-240. In other words, the one or more conductive elements can be disposed in each conductive layer, i.e., each of the first, second, third, fourth conductive layers 210-240 includes the one or more conductive elements. The PCB 200 can further include a plurality of electronic components, traces, and vias (see e. g., traces 322, 332 in Fig. 3A). Such vias and traces can electrically interconnect the conductive elements of different conductive layers.

The electronic components may be electrically interconnected by the conductive elements. The electronic components may include one or more of a resistor, a capacitor, a diode, an integrated circuit (IC), a battery, and the like. The conductive elements may include conductive tracks, conductive pads, conductive traces, conductive fills, and the like. In some embodiments, the conductive elements may be made of copper. A conductivity of the conductive elements may be at least about $2 \times 10^7$ Siemens per meter (S/m). The conductive elements may have any suitable shape and dimensions as per desired application attributes. In some embodiments, the conductive elements may be disposed in different conductive layers. The conductive elements disposed in different conductive layers may be electrically interconnected by vias. In some embodiments, one or more magnetic core structures may be provided, which in combination with the conductive elements on the PCB 200, may form planar magnetic components, such as inductors and transformers.

The conductive elements can be disposed in different thermal zones and different conductive layers may be electrically isolated from each other by providing electrical shielding between the conductive elements disposed in the different thermal zones and the different conductive layers. The electrical shielding may include ground planes. In some embodiments, the ground planes may include copper. In some exemplary PCBs, the conductive elements disposed in different conductive layers may not be electrically shielded from each other, i.e., ground planes between the conductive layers are not provided. Consequently, the exemplary PCB 200 may have to be designed such that certain safety criteria are met for the conductive elements that are not electrically shielded from each other.

For example, each conductive element can be included in a corresponding thermal zone. Furthermore, each thermal zone can include one or more electronic components. Each individual thermal zone may be defined as a zone including a collection of the conductive elements and the electronic components that does not violate the IS standards when shorted together. More specifically, the collection of the conductive elements and the electronic components does not generate enough heat to violate the IS standards when shorted together. In certain cases, the collection of the conductive elements and the electronic components does not generate a spark that violates the IS standards when shorted together.

The conductive elements disposed in different thermal zones may need to be electrically isolated from each other in order to comply with the IS standards. The conductive elements disposed in different thermal zones may be electrically isolated from each other by providing adequate distances between the conductive elements disposed in different thermal zones. Therefore, a distance between the conductive elements disposed in different thermal zones that are not electrically shielded from each other must be greater than or equal to a minimum clearance defined by the IS standards, to satisfy the IS standards, such as IEC60079 and the like.

In some embodiments, the first conductive layer 210 may be coated by a solder mask. Similarly, the fourth conductive layer 240 may also be coated by the solder mask. The solder mask may protect the conductive elements of the first conductive layer 210 and the fourth conductive layer 240 against dust, moisture, and oxidation.

Referring back to the flowcharts of Figs. 1A and 1B, and with reference to the schematic views of Figs. 3A-3F, embodiments of a method for evaluating a minimum clearance distance between a first and a second conductive element included in a printed circuit board (PCB) will now be described in further detail. As mentioned previously, the method 10, 100 may be computer implemented. In some embodiments, the method 10, 100 may be stored as software in the memory of a computer and can be executed by one or more processors located in the computer or computing device. In addition, methods 10, 100 are not required to be performed in the sequence described herein, but the steps of each method can be performed in one or more different orders. In addition, as will be apparent, depending on several factors, including the number of layers of the PCB under evaluation, one or more of the steps shown in Figs. 1A and 1B may not be needed to perform the minimum clearance evaluation.

As discussed above, the PCB 200 includes the one or more conductive layers 210-240, a plurality of conductive elements (such as conductive elements 312 and 342 shown in Fig. 3A), and a plurality of electronic components (such as traces 322, 332 shown in Fig. 3A).

In one embodiment, a method 10 is shown in Fig. 1A. Step 12 includes selecting a first conductive element (A) (see e. g., Fig. 3A) disposed on a first outer conductive layer and a second conductive element (B) disposed on a second outer conductive layer of the PCB, a clearance between which has a minimum spacing requirement.

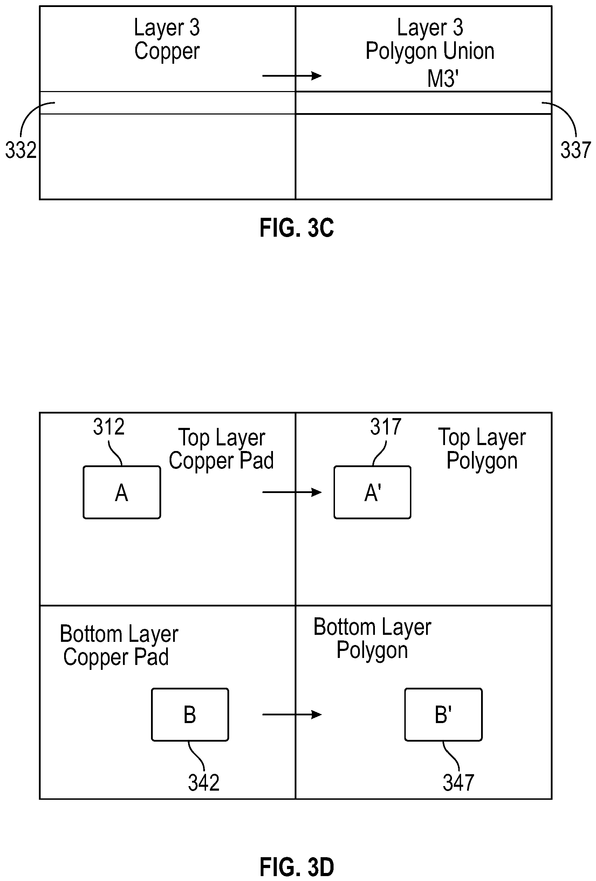

The method 10 also comprises step 14, which includes creating polygons of the first and second conductive elements, where a polygon of the first conductive element is denoted A' and a polygon of the second conductive element is denoted B' (see e. g., elements 317 and 347 in Fig. 3D). The polygon is geometric shape corresponding to the shape of the conductive element.

The method 10 also comprises step 16, which includes determining if there is at least one conductive layer disposed between the conductive layers where A' and B' are disposed. If a different conductive layer is disposed between the first and second outer conductive layers, method 100 shown in Fig. 1B can be utilized (step 19).

If no conductive layer is disposed between A' and B', then A" and B" are created on an evaluation layer in step 18. The evaluation layer is not an actual layer of the PCB, but a simulated layer generated by the software. In this aspect, polygon A" has the same shape as polygon A' and polygon B" has the same shape as polygon B'.

The method 10 comprises a step 20 that includes calculating a shortest unshielded distance (dxy) between A" and B", which includes using a distance between the conductive layers (dz), and calculating an unshielded distance (d), wherein

$$d = \sqrt{dxy^2 + dz^2}$$

. If the calculated distance d is less than the minimum spacing requirement, a violation is indicated in step 22.

In another aspect, in step 24, the method 10 can be repeated for evaluating the distances between an additional conductive element included in the PCB and element A. For example, the computer-implemented method can further comprises selecting a third conductive element (C) of the PCB and repeating steps 12, 14, 16, 18, 20, and 22. For this additional conductive element C, polygons of the first and third conductive elements can be created, wherein a polygon of the first conductive element is A' and a polygon of the third conductive element is C'. In another aspect, the method also comprises determining if there is at least one conductive layer disposed between A' and C'. If no conductive layer is disposed between conductive elements A and C, then A" and B" are created on the evaluation layer. The method comprises calculating the shortest unshielded distance (dxy) between A" and C", which includes using a distance between the outer conductive layers (dz) to calculate the unshielded distance (d), wherein

$$d = \sqrt{dxy^2 + dz^2}$$

. If the calculated distance d is less than the minimum spacing requirement, a violation is indicated.

In another aspect, in the event that the PCB includes a plurality of outer conductive layers and at least one inner conductive layer, the method 100 shown in Fig. 1B can be utilized. In this aspect, referring to PCB 200 shown in Fig. 2, the plurality of conductive layers of the PCB includes a first outer conductive layer, such as outer conductive layer 210 a second outer conductive layer, such as outer conductive layer 240, and at least one internal conductive layer, such as one or both of inner conductive layers 220, 230, disposed between the outer conductive layers.

In step 105, for each internal conductive layer, the computer-implemented method further comprises creating a polygon of each conductive element disposed on the internal conductive layer(s). For example, as shown in Fig. 3A, PCB 300 includes a four-layer structure (TOP, LY2, LY3, and BOTTOM). The internal conductive layers (LY2, LY3) include conductive elements, such as traces 322, copper pour 324, and trace 332.

For a first internal conductive layer LY2 (which, for purposes of this example, corresponds to layer 220 of PCB 200), the method comprises step 110 which includes implementing a union operator to create a first polygon mask layer (Mx) by combining polygons of every conducive element disposed on first inner conductive layer LY2. In the example shown in Fig. 3B, a union operator is utilized to create a polygon union M2'. For example, Fig. 3B shows mask layer M2' including a polygon 327 corresponding to traces 322. In the example shown in Fig. 3C, a union operator is utilized to create a polygon union M3', where polygon 337 corresponds to trace 332 of LY3.

In step 115, two conductive elements are selected. The selected elements have a minimum spacing requirement that is to be evaluated. The selected elements can be disposed in different thermal zones and are not electrically shielded from one another. For example, as shown in Fig. 3A, two conductive elements are selected - conductive pad 312 (element A) disposed on the TOP outer conductive layer and conductive pad 342 (element B) disposed on the BOT outer conductive layer. In this example, two inner conductive layers (and the elements disposed thereon) are formed between the outer conductive layers. As such, the method 100 can evaluate the shortest unshielded distance between elements A and B to determine if the design is in compliance with minimum spacing requirements.

Step 120 includes creating polygons of the first and second conductive elements, where a polygon of the first conductive element (A) is denoted A' and a polygon of the second conductive element (B) is denoted B' (see e. g., Fig. 3D).

In step 125, it is determined whether there are any conductive layers disposed between the outer conductive layers containing conductive elements A' and B'. In the example of Figs. 3A-3F, inner conductive layers LY2 and LY3 are disposed between the outer conductive layers.

In step 130, method 100 includes implementing an intersection operator to determine where the first polygon mask layer (M2') overlaps the polygon of the first conductive element A'.

In another aspect, in step 135, the computer-implemented method 100 further comprises implementing a difference operator to remove areas of the polygon of the first conductive element A' where the first polygon mask layer M2' overlaps the polygon of the first conductive element A', creating A" on an evaluation layer 325. This step can be repeated for each mask layer (see e. g., step 150). For example, as shown in the upper half of Fig. 3E, A" is formed by subtracting M2' + M3' from A'. In the embodiment described previously with respect to method 10, where there are no intervening layers disposed between the Top layer and the Bottom layer, A" is equal to A' (i.e., A" and A' have the same polygonal shape).

In another aspect, in step 140, the computer-implemented method further comprises implementing an intersection operator to determine where the first polygon mask layer overlaps the polygon of the second conductive element B'.

In step 145, method 100 includes implementing a difference operator to remove areas of the polygon of the second conductive element B' where the first polygon mask layer Mx overlaps the polygon of the second conductive element B', creating B" on the evaluation layer 325. For example, as shown in the lower half of Fig. 3E, B" is formed by subtracting M2' + M3' from B'.

In step 150, the preceding steps are repeated for each mask disposed between elements A and B. For example, for the second internal conductive layer (LY3), a union operator can be used to create another polygon mask layer (M3'). An intersection operator can be used to determine where M3' overlaps the polygon of the first conductive element A' and a difference operator can be used to remove areas of the polygon of the first conductive element A' where the mask layer M3' overlaps the polygon of the first conductive element A', forming A" on the evaluation layer 325. In addition, an intersection operator can be used to determine where M3' overlaps the polygon of the second conductive element B'. A difference operator can be used to remove areas of the polygon of the second conductive element B' where the mask layer M3' overlaps the polygon of the second conductive element B', forming B" on the evaluation layer 325 (see e. g., Fig. 3E).

In another aspect, in step 155, the computer-implemented method further comprises calculating a shortest unshielded distance (dxy) between A" and B" on the evaluation layer. For example, Fig, 3F shows an X-Y clearance distance of dxy that is measured between the nearest points on A" and B".

Further, in step 160, using a distance between the outer conductive layers (dz), which is a known distance along a normal to the plane of at least one outer conductive layer, an unshielded distance (d) is calculated, wherein $d = \sqrt{dxy^2 + dz^2}$ .

In step 165, it is determined if the distance (d) is less than the minimum clearance distance requirement between unshielded components. For example, if the distance (d) is greater than the minimum clearance distance requirement, then the PCB conforms to the standards defined in, for example, IEC60079.

If the calculated distance d is less than the minimum spacing requirement, a violation is indicated in step 170. This violation can be indicated to the user of the PCB design program being implemented. For example, indicating the spacing violation may include generating a report including the details of the conductive elements of the PCB that violate the minimum clearance. In some embodiments, indicating the spacing violation may include highlighting the conductive elements of the PCB that violate the minimum clearance in the EDA software. In some embodiments, indicating the spacing violation may further include reporting the spacing violation by a design check rule (DRC) of the EDA software. If there is such a violation, the user can then adjust or modify the positions of conductive elements A and/or B using the design software, and the process can be repeated until no minimum spacing violations are present.

In addition, for one or more additional conductive elements, the computer-implemented method can further include selecting a third conductive element (C) of the PCB and repeating relevant steps of method 100 as needed. The method steps can be repeated for additional conductive elements depending on the design of the PCB.

The computer-implemented method may further aid in designing a PCB with increased packing density, thereby decreasing a size of the PCB without violating the IS standards. Decreasing the size of the PCB may further allow designing smaller safety devices, thereby improving portability of the safety devices. Therefore, the safety devices including a PCB designed by the computer-implemented method may be both safe to operate in hazardous environments and have improved portability.

The methods 10, 100 can be implemented in an exemplary computing device. In some embodiments, the computing device may be a desktop computer or a portable computer. The computing device may execute and automate various methods and processes. In some embodiments, one or more of the computing devices may execute a method for evaluating minimum clearance distances. The computing device can include a processor and a memory. The computing device can further include a user interface communicably coupled to the processor. The processor may include any suitable type of processing circuitry, such as one or more of a general-purpose processor (e. g., ARM-based processor), a Digital Signal Processor (DSP), a Programmable Logic Device (PLD), an Application-Specific Integrated Circuit (ASIC), a Field-Programmable Gate Array (FPGA), etc. In operation, the processor may execute, for example, a control and/or communication-related operation or data processing for at least one other component of the computing device.

The user interface may include input devices, such as a mouse and a keyboard, for receiving inputs from a user. The user interface may further include output devices, such as a monitor and speakers for providing outputs to the user. In some cases, the user interface may include a touch sensitive interface.

The memory may include any suitable type of volatile and/or non-volatile memory, such as Random-access Memory (RAM), Read-Only Memory (ROM), Network Accessible Storage (NAS), cloud storage, a Solid State Drive (SSD), etc. The memory may store, for example, a command or data related to at least one other component of the computing device. In some embodiments, the memory may store software and/or a program.

The memory may store an IS ruleset corresponding to PCB design criteria defined by the IS standards. In some embodiments, the IS ruleset includes a clearance ruleset.

The clearance ruleset may define a minimum distance between the conductive elements disposed in the different thermal zones of the PCB 200. The minimum distance may be required for isolation purposes, i.e., electrically isolating the conductive elements disposed in different thermal zones. For example, the minimum distance between the conductive elements disposed in different thermal zones of the PCB 200 may range from about 0.2 mm to about 70 mm. The PCB 200 may be designed such that a distance between conductive elements disposed in different thermal zones is greater than the minimum distance defined by the clearance ruleset, such that the PCB 200 is compliant with the IS standards.

The memory may further store an application programming interface (API) (not shown). The memory may further store an electronic design automation (EDA) software. The EDA software may be used to design the PCB 200. Examples of EDA software include, but are not limited to, Altium, Eagle, Cadence, OrCAD, etc. The EDA software may import the API from the memory. The EDA software may be used to generate a circuit design of the PCB 200, and further generate a PCB layout of the PCB 200. The EDA software may further generate a "GERBER" file or the like, that may be fed into a PCB fabrication machine to fabricate the PCB 200. The memory may further store the PCB layout. The PCB layout includes geometric data of each conductive layer 210-240 of the PCB 200. In some embodiments, the geometric data may include relative geometric positions of the conductive layers, the conductive elements, and the electronic components of the PCB 200.

The memory may further store a library and a schematic.

The schematic can include data about each electronic component disposed in the corresponding thermal zone. For example, the schematic may include data about each thermal zone of the PCB 200-In some embodiments, the schematic may be based on the PCB layout. The schematic may be retrieved by any component of the computing device. In some embodiments, the schematic may be retrieved by the EDA software.

In the present detailed description of the preferred embodiments, reference is made to the accompanying drawings, which illustrate specific embodiments in which the invention may be practiced. The illustrated embodiments are not intended to be exhaustive of all embodiments according to the invention. It is to be understood that other embodiments may be utilized, and structural or logical changes may be made without departing from the scope of the present invention. The following detailed description, therefore, is not to be taken in a limiting sense, and the scope of the present invention is defined by the appended claims.

Unless otherwise indicated, all numbers expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein.

As used in this specification and the appended claims, the singular forms "a," "an," and "the" encompass embodiments having plural referents, unless the content clearly dictates otherwise. As used in this specification and the appended claims, the term "or" is generally employed in its sense including "and/or" unless the content clearly dictates otherwise.

Spatially related terms, including but not limited to, "proximate," "distal," "lower," "upper," "beneath," "below," "above," and "on top," if used herein, are utilized for ease of description to describe spatial relationships of an element(s) to another. Such spatially related terms encompass different orientations of the device in use or operation in addition to the particular orientations depicted in the figures and described herein. For example, if an object depicted in the figures is turned over or flipped over, portions previously described as below or beneath other elements would then be above or on top of those other elements.

As used herein, when an element, component, or layer for example is described as forming a "coincident interface" with, or being "on," "connected to," "coupled with," "stacked on" or "in contact with" another element, component, or layer, it can be directly on, directly connected to, directly coupled with, directly stacked on, in direct contact with, or intervening elements, components or layers may be on, connected, coupled or in contact with the particular element, component, or layer, for example. When an element, component, or layer for example is referred to as being "directly on," "directly connected to," "directly coupled with," or "directly in contact with" another element, there are no intervening elements, components or layers for example. The techniques of this disclosure may be implemented in a wide variety of computer devices, such as servers, laptop computers, desktop computers, notebook computers, tablet computers, hand-held computers, smart phones, and the like. Any components, modules or units have been described to emphasize functional aspects and do not necessarily require realization by different hardware units. The techniques described herein may also be implemented in hardware, software, firmware, or any combination thereof. Any features described as modules, units or components may be implemented together in an integrated logic device or separately as discrete but interoperable logic devices. In some cases, various features may be implemented as an integrated circuit device, such as an integrated circuit chip or chipset. Additionally, although a number of distinct modules have been described throughout this description, many of which perform unique functions, all the functions of all of the modules may be combined into a single module, or even split into further additional modules. The modules described herein are only exemplary and have been described as such for better ease of understanding.

If implemented in software, the techniques may be realized at least in part by a computer-readable medium comprising instructions that, when executed in a processor, performs one or more of the methods described above. The computer-readable medium may comprise a tangible computer-readable storage medium and may form part of a computer program product, which may include packaging materials. The computer-readable storage medium may comprise random access memory (RAM) such as synchronous dynamic random access memory (SDRAM), read-only memory (ROM), non-volatile random access memory (NVRAM), electrically erasable programmable read-only memory (EEPROM), FLASH memory, magnetic or optical data storage media, and the like. The computer-readable storage medium may also comprise a non-volatile storage device, such as a hard-disk, magnetic tape, a compact disk (CD), digital versatile disk (DVD), Blu-ray disk, holographic data storage media, or other non-volatile storage device.

The term "processor," as used herein may refer to any of the foregoing structure or any other structure suitable for implementation of the techniques described herein. In addition, in some aspects, the functionality described herein may be provided within dedicated software modules or hardware modules configured for performing the techniques of this disclosure. Even if implemented in software, the techniques may use hardware such as a processor to execute the software, and a memory to store the software. In any such cases, the computers described herein may define a specific machine that is capable of executing the specific functions described herein. Also, the techniques could be fully implemented in one or more circuits or logic elements, which could also be considered a processor.

In one or more examples, the functions described may be implemented in hardware, software, firmware, or any combination thereof. If implemented in software, the functions may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e. g., according to a communication protocol. In this manner, computer-readable media generally may correspond to (1) tangible computer-readable storage media, which is non-transitory or (2) a communication medium such as a signal or carrier wave. Data storage media may be any available media that can be accessed by one or more computers or one or more processors to retrieve instructions, code and/or data structures for implementation of the techniques described in this disclosure. A computer program product may include a computer-readable medium.

By way of example, and not limitation, such computer-readable storage media can comprise RAM, ROM, EEPROM, CD-ROM or other optical disk storage, magnetic disk storage, or other magnetic storage devices, flash memory, or any other medium that can be used to store desired program code in the form of instructions or data structures and that can be accessed by a computer. Also, any connection is properly termed a computer-readable medium. For example, if instructions are transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. It should be understood, however, that computer-readable storage media and data storage media do not include connections, carrier waves, signals, or other transient media, but are instead directed to non-transient, tangible storage media. Disk and disc, as used, includes compact disc (CD), laser disc, optical disc, digital versatile disc (DVD), floppy disk and Blu-ray disc, where disks usually reproduce data magnetically, while discs reproduce data optically with lasers. Combinations of the above should also be included within the scope of computer-readable media.

Instructions may be executed by one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor", as used may refer to any of the foregoing structure or any other structure suitable for implementation of the techniques described. In addition, in some aspects, the functionality described may be provided within dedicated hardware and/or software modules. Also, the techniques could be fully implemented in one or more circuits or logic elements.

The techniques of this disclosure may be implemented in a wide variety of devices or apparatuses, including a wireless handset, an integrated circuit (IC) or a set of ICs (e. g., a chip set). Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperative hardware units, including one or more processors as described above, in conjunction with suitable software and/or firmware.

It is to be recognized that depending on the example, certain or events of any of the methods described herein can be performed in a different sequence, may be added, merged, or acts left out altogether (e. g., not all described acts or events are necessary for the practice of the method). Moreover, in certain examples, acts or events may be performed concurrently, e. g., through multi-threaded processing, interrupt processing, or multiple processors, rather than sequentially.

In some examples, a computer-readable storage medium includes a non-transitory medium. The term "non-transitory" indicates, in some examples, that the storage medium is not embodied in a carrier wave or a propagated signal. In certain examples, a non-transitory storage medium stores data that can, over time, change (e. g., in RAM or cache).

Various examples have been described. These and other examples are within the scope of the following claims.

**Claims**

1. A computer-implemented method for evaluating a minimum clearance distance between a first and a second conductive element included in a printed circuit board (PCB), the PCB comprising a plurality of conductive layers and a plurality of conductive elements, each conductive layer comprising one or more conductive elements, the plurality of conductive layers comprising one or more outer conductive layers, the method executed by one or more processors of one or more computing devices, the method comprising:

   selecting a first conductive element (A) disposed on a first outer conductive layer and a second conductive element (B) disposed on a second outer conductive layer of the PCB, a clearance between which has a minimum spacing requirement;
   creating polygons of the first and second conductive elements, wherein a polygon of the first conductive element is A' and a polygon of the second conductive element is B';
   determining if there is at least one conductive layer disposed between A' and B';
   if no conductive layer is disposed between A' and B', creating A" and B" on an evaluation layer;

calculating a shortest unshielded distance (dxy) between A" and B";

using a distance between the conductive layers (dz), calculating a distance (d), wherein

$$d = \sqrt{dxy^2 + dz^2}$$ ; and

indicating a violation if the calculated distance d is less than the minimum spacing requirement.

2. The computer-implemented method of claim 1, further comprising:

selecting a third conductive element (C) of the PCB;

creating polygons of the first and third conductive elements, wherein a polygon of the first conductive element is A' and a polygon of the third conductive element is C',;

determining if there is at least one conductive layer disposed between A' and C';

if no conductive layer is disposed between A' and C', creating C" on an evaluation layer calculating the shortest distance (dxy) between A" and C";

using a distance between the outer conductive layers (dz), calculating the distance (d), wherein

$$d = \sqrt{dxy^2 + dz^2}$$ ; and

indicating a violation if the calculated distance d is less than the minimum spacing requirement.

3. The computer-implemented method of claim 1, wherein the plurality of conductive layers includes a first outer conductive layer, a second outer conductive layer, and at least one internal conductive layer disposed between the outer layers, further comprising:

for each internal conductive layer, creating a polygon of each element disposed on the internal conductive layer;

for a first internal conductive layer, implementing a union operator to create a first polygon mask layer (Mx);

for the first internal conductive layer, implementing an intersection operator to determine where the first polygon mask layer overlaps the polygon of the first conductive element A'.

4. The computer-implemented method of claim 3, further comprising:
implementing a difference operator to remove areas of the polygon of the first conductive element A' where the first polygon mask layer Mx overlaps the polygon of the first conductive element A', creating A" on the evaluation layer.

5. The computer-implemented method of claim 4, further comprising:

implementing an intersection operator to determine where the first polygon mask layer overlaps the polygon of the second conductive element B'; and

implementing a difference operator to remove areas of the polygon of the second conductive element B' where the first polygon mask layer Mx overlaps the polygon of the second conductive element B', creating B" on the evaluation layer.

6. The computer-implemented method of claim 5, further comprising:
determining a shortest unshielded distance (dxy) between A" and B" on the simulation layer.

7. The computer-implemented method of claim 6, further comprising:

using a distance between the outer conductive layers (dz), calculating a distance (d), wherein

$$d = \sqrt{dxy^2 + dz^2}$$ ; and

indicating a violation if the calculated distance d is less than the minimum spacing requirement.

8. The computer-implemented method of claim 3, wherein the plurality of conductive layers includes first and second internal conductive layers each disposed between the outer layers, further comprising:

for the second internal conductive layer, implementing a union operator to create a second polygon mask layer (My);

implementing an intersection operator to determine where the second polygon mask layer overlaps the polygon of the first conductive element A',

implementing a difference operator to remove areas of the polygon of the first conductive element A' where the second polygon mask layer My overlaps the polygon of the first conductive element A', forming A" on the evaluation layer;

implementing an intersection operator to determine where the second polygon mask layer overlaps the polygon of the second conductive element B';

implementing a difference operator to remove areas of the polygon of the second conductive element B' where the second polygon mask layer My overlaps the polygon of the second conductive element B', forming B";

determining a shortest unshielded distance (dxy) between A" and B" on the evaluation layer;

using a distance between the conductive layers (dz), calculating a distance (d), wherein

$$d = \sqrt{dxy^2 + dz^2}$$ ; and

indicating a violation if the calculated distance d is less than the minimum spacing requirement.

9. The computer-implemented method of claim 1, wherein the indicating step includes providing a visual indication that the calculated distance is less than the minimum spacing requirement.

10 ⟍

```
                          ┌─ 12
        ┌──────────────────────────────────────┐
        │   Select 2 conductive elements (A, B)  │
        └──────────────────────────────────────┘
                            │
                          ┌─ 14
        ┌──────────────────────────────────────┐
        │  Create polygons for 1st and 2nd       │
        │  conductive elements (A', B' )          │
        └──────────────────────────────────────┘
                            │
                          ┌─ 16
        ┌──────────────────────────────────────┐
  YES   │  Determine if there is at least 1      │   NO
 ◄──────┤  conductive layer disposed between A, B├──────►
        └──────────────────────────────────────┘
```

┌─ 19                                              18 ─┐
┌────────────────────────────┐      ┌────────────────────────────────┐
│      See method 100         │      │  Calculate shortest distance (dxy) │
└────────────────────────────┘      │         between A", B"             │
                                     └────────────────────────────────┘

20 ─┐
┌──────────────────────────────────────┐
│  Use layer spacing distance to calculate (d) │
│                                        │
│       $d = \sqrt{dxy^2 + dz^2}$        │
└──────────────────────────────────────┘

┌─ 22
┌──────────────────────────────────────┐
│  If d < min spacing distance requirement, │
│          indicate violation            │
└──────────────────────────────────────┘

┌─ 24
┌──────────────────────────────────────┐
│  Repeat for additional conductive elements │
└──────────────────────────────────────┘

**FIG. 1A**

```
100 ⌐        105 ⌐
         ┌────────────────────────────────┐
         │ For each internal conductive layer, create │
         │ a polygon of each element.         │
         └────────────────────────────────┘
                        ↓
         110 ⌐
         ┌────────────────────────────────┐
         │ For each internal conductive layer, use a │
         │ 'union' operator to create a single    │
         │ polygon "mask"; M2', M3', etc.       │
         └────────────────────────────────┘
                        ↓
         115 ⌐
         ┌────────────────────────────────┐
         │ Choose 2 elements, A and B, the      │
         │ clearance between which is important   │
         │ to know                  │
         └────────────────────────────────┘
                        ↓
         120 ⌐
         ┌────────────────────────────────┐
         │ Create polygons of both elements, A'   │
         │ and B'                  │
         └────────────────────────────────┘
                        ↓
         125 ⌐
         ┌────────────────────────────────┐
         │ Determine if there is at least one layer │
         │ between the two chosen elements.     │
         └────────────────────────────────┘
                        ↓
         130 ⌐
         ┌────────────────────────────────┐
         │ Use an 'intersection' method to find any │
         │ areas where Mx' overlaps A', creating  │
         │ A", on an evaluation layer        │
         └────────────────────────────────┘
                        ↓
         135 ⌐
         ┌────────────────────────────────┐
         │ Using a 'difference' method, remove the │
         │ areas of A' where MX' overlaps.      │
         └────────────────────────────────┘
```

```
         ⌐ 140
         ┌────────────────────────────────┐
         │ Use an 'intersection' method to find any │
         │ areas where MX' overlaps B'.       │
         └────────────────────────────────┘
                        ↓
         ⌐ 145
         ┌────────────────────────────────┐
         │ Using a 'difference' method, remove the │
         │ areas of B' where MX' overlaps, creating │
         │ B" on an evaluation layer         │
         └────────────────────────────────┘
                        ↓
         ⌐ 150
         ┌────────────────────────────────┐
         │ Repeat for each mask between A and B.  │
         └────────────────────────────────┘
                        ↓
         ⌐ 155
         ┌────────────────────────────────┐
         │ Determine the distance between the    │
         │ remaining areas of A" and B".       │
         └────────────────────────────────┘
                        ↓
         ⌐ 160
         ┌────────────────────────────────┐
         │ Using knowledge of the PCB layer     │
         │ distances, calculate the minimum     │
         │ required clearance between A" and B".  │
         └────────────────────────────────┘
                        ↓
         ⌐ 165
         ┌────────────────────────────────┐
         │ Determine if this distance is less than │
         │ the minimum clearance requirement.    │
         └────────────────────────────────┘
                        ↓
         ⌐ 170
         ┌────────────────────────────────┐
         │ If so, record a violation between A and B. │
         └────────────────────────────────┘
```

**FIG. 1B**

200

**FIG. 2**

**FIG. 3A**

**FIG. 3B**

| Layer 3 Copper | Layer 3 Polygon Union M3' |
|---|---|
| 332 | 337 |

**FIG. 3C**

| Top Layer Copper Pad | Top Layer Polygon |
|---|---|
| 312 A | 317 A' |
| Bottom Layer Copper Pad | Bottom Layer Polygon |
| B 342 | B' 347 |

**FIG. 3D**

A' - (M2' + M3') = A"

A"

$A' - (M2' + M3') = A''$

$B' - (M2' + M3') = B''$

B"

325

**FIG. 3E**

A"

X-Y Clearance, dxy

B"

325

**FIG. 3F**

Europäisches
Patentamt

European
Patent Office

Office européen
des brevets

# EUROPEAN SEARCH REPORT

**Application Number**

EP 24 19 4735

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2022/074504 A1 (3M INNOVATIVE PROPERTIES CO [US]) 14 April 2022 (2022-04-14) * page 1, line 33 - page 2, line 19 * * page 6, lines 19-34 * * page 10, lines 7,8,16-22 * * page 18, lines 3-27 * * page 22, line 32 - page 23, line 20 * ----- | 1-9 | INV. G06Q10/04 G06F30/398 H05K3/00 |
| Y | US 2022/382955 A1 (WANG CHAO-MIN [TW] ET AL) 1 December 2022 (2022-12-01) * paragraphs [0026], [0031], [0045], [0046] * ----- | 1-9 | |
| | | | TECHNICAL FIELDS SEARCHED (IPC) G06Q H05K G06F |

The present search report has been drawn up for all claims

| Place of search | Date of completion of the search | Examiner |
|---|---|---|
| Munich | 16 December 2024 | Breidenich, Markus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 4735

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2024

| Patent document cited in search report | Publication date | Patent family member(s) | Publication date |
|---|---|---|---|
| WO 2022074504 A1 | 14-04-2022 | EP 4226747 A1<br>US 2023385517 A1<br>WO 2022074504 A1 | 16-08-2023<br>30-11-2023<br>14-04-2022 |
| US 2022382955 A1 | 01-12-2022 | NONE | |

EPO FORM P0459

For more details about this annex : see Official Journal of the European Patent Office, No. 12/82